# EUROPEAN PATENT APPLICATION

(11) **EP 4 471 844 A1**
(43) Date of publication of application: **04.12.2024**
(21) Application number: 23176403.6
(22) Date of filing: 31.05.2023
(51) Int. Cl.: H01L 23/13, B81B 7/00, H01L 23/498, H01L 25/07, H01L 23/538, H01L 23/31

(54) **ELECTRONIC COMPONENT WITH IMPROVED BOARD LEVEL RELIABILITY**

(71) Applicant: Murata Manufacturing Co., Ltd., Nagaokakyo-shi, Kyoto 617-8555 (JP)
(72) Inventor: NURMI, Sami, 04320 Tuusula (FI)
(74) Representative: Boco IP Oy Ab

(57) **Abstract**

The disclosure describes an arrangement that allows Board Level Reliability improvement of microelectromechanical components. The result is achieved by including an outer metallic surface to at least one of the walls of the bottom package. During the process of soldering the electronic component to an external printed circuit board the metallic surface is also soldered to the external board which results in an increase of the solder area and height.

## Description

### FIELD OF THE DISCLOSURE

This disclosure relates to electronic components, and more particularly to packaging electronic components. The present disclosure further concerns packages with a structure for Board Level Reliability (BLR) improvement.

### BACKGROUND OF THE DISCLOSURE

Electronic chips, also known as dies, are prepared by manufacturing various electronic structures on a substrate and cutting the substrate into small, chip-size pieces. These dies may be microelectromechanical systems (MEMS) electronic devices formed from a silicon wafer by microfabrication techniques. Each chip can be placed inside a protective package which forms an enclosure where the chip is protected from the surrounding environment. The chip can be mechanically attached to a support structure inside the enclosure, such as a die pad, and electrically connected to contacts which extend outside of the enclosure. The packaged chip forms an electronic component which can be mounted on a printed circuit board (PCB).

Electronic components typically comprise at least one electronic chip and a package. The package frame can be made of a hollow plastic box, a hollow metal cap or molded epoxy resin in which electronic devices are embedded. The chips are usually mounted on an internal printed circuit board inside the component package and may be electrically connected to an external printed circuit board via soldering bumps which extend out of the package. Some components may also have electronic chips attached to the bottom of the internal printed circuit board. The package frame will then have a top half enclosing the chips that are attached to the top of the internal printed circuit board and a bottom half enclosing the chips that are attached to the bottom of the internal printed circuit board. Such components may also comprise pillar contacts extending out of the bottom half of the package to which the solder bumps are connected.

Solder connections can be tested by performing a Board Level Reliability (BLR) test which evaluates the quality of the connections after mounting the component on the external circuit board. The Board Level Reliability test is a thermal cycle test that involves exposing the structure to high and low temperature cycles (typically from -40°C to 125°C) in order to evaluate the reliability of the package performance in extreme operating conditions. At such temperatures, solder bumps can become an inherent weakness that affects the reliability of MEMS packages.

### BRIEF DESCRIPTION OF THE DISCLOSURE

An object of the present disclosure is to provide a solution to the problem described above. The disclosed solution allows Board Level Reliability improvement of microelectromechanical components. Examples provided in this disclosure describe ways to implement the solution. The improvement is achieved by features of the microelectromechanical component and a manufacturing method.

The object of the disclosure is achieved by an arrangement which is characterized by what is stated in the independent claims. The preferred embodiments of the disclosure are disclosed in the dependent claims.

The disclosure is based on the idea of including a metallic surface to the outside surface of at least one of the side walls of the bottom package in a microelectromechanical component. During the process of soldering the electronic component to an external printed circuit board, in addition to the deposition of solder bumps, the metallic surface is also soldered to the external board which results in an increase of the solder area and height. This provides new improvements in Board Level Reliability of the electronic component.

### BRIEF DESCRIPTION OF THE DRAWINGS

In the following, the disclosure will be described in greater detail by means of preferred embodiments with reference to the accompanying drawings, in which
Figure 1a-1b illustrate examples of sectional views of electronic components with a bottom package comprising a side wall. The outside surface of the side wall comprises a metallic surface;
Figures 2a illustrates another example of a sectional view of an electronic component with a bottom package comprising a side wall. The outside surface of the side wall comprises a metallic surface;
Figures 2b-2c illustrate possible bottom views of the electronic component in figure 2a;
Figures 2d illustrates another possible bottom view of the electronic component in figure 2a. The outside surface of the side wall comprises more than one metallic surface;
Figures 3a illustrates a further example of a sectional view of an electronic component with a side wall comprising a metallic surface. The metallic surface protrudes outwards beyond the edge of the internal horizontal circuit board;
Figures 3b-3c illustrate possible bottom views of the electronic component in figure 3a;
Figures 4a illustrates an example of a sectional view of an electronic component with a bottom package comprising a metallic surface. The metallic surface is a portion of the whole outside surface of the side wall;
Figures 4b-4c illustrate possible bottom views of the electronic component in figure 4a;
Figures 5a-5d illustrate examples of the bottom view of electronic components with a bottom package comprising a side wall. The outside surface of the side wall comprises a castellations-shaped metallic surface;
Figures 6a illustrates an example of a sectional view of an electronic component wherein two side walls of the bottom package comprise a metallic surface. The side walls comprising a metallic surface are parallel to each other;
Figure 6b illustrates an example of the bottom view of an electronic component wherein two side walls of the bottom package comprise a metallic surface. The two side walls are parallel to each other;
Figure 6c illustrates another example of the the bottom view of an electronic component wherein two side walls of the bottom package comprise a metallic surface. The two side walls are perpendicular to each other;
Figure 7 illustrates an example of a sectional view of an electrical component connected to an external circuit board;
Figures 8a-8f illustrate examples of different circuit boards that can be used to form a metallic surface in a side wall of a bottom package;
Figures 9a-9c provide a simplified illustration of an example method for forming at least one side wall in the bottom package of an electronic component wherein the outside surface of the side wall comprises a metallic surface;
Figures 9d shows the electronic component manufactured using the method illustrated in figures 9a-9c after it is connected to an external circuit board;

### DETAILED DESCRIPTION OF THE DISCLOSURE

The disclosure describes an electronic component comprising a horizontal circuit board with a top side and a bottom side. The horizontal circuit board defines a horizontal xy-plane and a vertical z-direction which is perpendicular to the xy-plane. The electronic component further comprises one or more dies attached to the top side of the horizontal circuit board and a top package. The top package is attached to the top side of the horizontal circuit board and surrounds the one or more dies. The electronic component further comprises a bottom package. The bottom package is attached to the bottom side of the horizontal circuit board so that the bottom surface of the bottom package forms the bottom side of the component. The bottom package comprises at least one side wall. The side wall comprises an outside surface, and the outside surface comprises a metallic surface.

The expression "a side wall" refers to one of the walls forming the lateral faces of the bottom package. In other words, "a side wall" defines a wall on any side of the bottom package except the top or the bottom sides. It may be formed by a single layer of material or by two or more layers attached to each other. The layers may be made of different materials. The expression "outside surface of a side wall" refers to the surface of the side wall which is facing the environment surrounding the bottom package. The expressions "top side of the component" and "bottom side of the component" refer here only to how the component is intended to be mounted, for example onto an external circuit board. The bottom side of the component is intended to be attached to the surface of the external circuit board. That external circuit board could be oriented in any manner. The expressions "top package" and "bottom package" relate to how the two packages are intended to be attached to the horizontal circuit board. The top side of the horizontal printed circuit board is the side on which the top package is attached. The bottom side of the horizontal printed circuit board is the side on which the bottom package is attached. Words such as "bottom" and "top", "above" and "below" do not refer to the orientation of the component with regard to the direction of earth's gravitational field either when the component is manufactured or when it is in use. The plane defined by the x- and y-axes is parallel to the plane of the printed circuit board to which the dies are attached. The direction defined by the z-axis is perpendicular to the same circuit board plane.

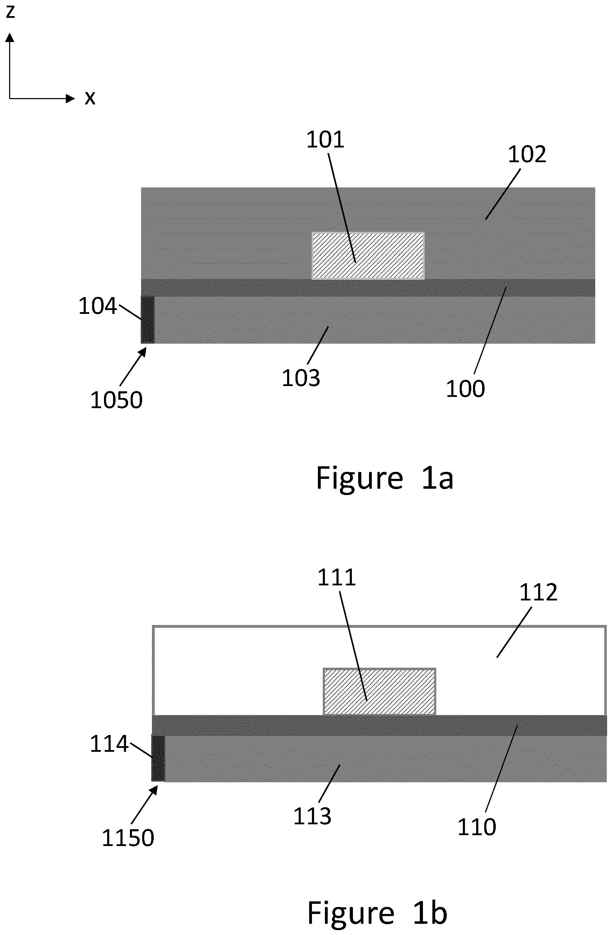

Figure 1a illustrates an example of a sectional view of an electronic component with a bottom package comprising a side wall. The outside surface of the side wall comprises a metallic surface. In this example, the electronic component comprises one die 101, such as a MEMS or ASIC chip, attached to the top side of a horizontal internal circuit board 100. The electronic component further comprises a top package 102 which is attached to the top side of the internal circuit board 100 and surrounds the die 101. The component may comprise more dies which may either be similar or different. The top package may either be a hollow plastic frame, a metal cap, or a molded solid substance. The molded solid substance may be made of materials that may include low conductivity or insulating materials such as mold compounds, polymers, plastics, ceramics, or resins. In this example, the top package 102 is a solid substance, such as resin, formed onto the internal circuit board 100 so that the dies are enclosed inside the package walls. The electronic component further comprises a bottom package 103 which is formed on the bottom side of the internal circuit board 100 so that the bottom surface of the bottom package forms the bottom side of the component. The bottom package 103 may be a hollow plastic frame or a molded solid substance. It may be made of materials that include low conductivity or insulating materials such as mold compounds, polymers, plastics, ceramics, or resins. These options may apply to any embodiment in this disclosure. The bottom package 103 comprises a side wall 1050 and the outside surface of the side wall comprises a metallic surface 104. The metallic surface 104 may be made of any metal to which solder material can adhere. Such metals include but are not limited to Cu, Ni, Au, Ag, Sn, Pt, Pd, or metal alloys. The metals may be formed by PCB fabrication processes such as lamination, electroplating, or electroless plating. These options may apply to all embodiments in this disclosure.

Figure 1b illustrates another example of a sectional view of an electronic component with a bottom package comprising a side wall. The outside surface of the side wall comprises a metallic surface. In this example, the top package 112 is a hollow frame such as a plastic or a metal cap. Reference numbers 110, 111, 113, 114 and 1150 in figure 1b correspond to reference numbers 100, 101, 103, 104 and 1050, respectively, in figure 1a.

The metallic surface may be a flat surface. It may be the whole outside surface of the side wall. Alternatively, it may be a portion of the outside surface of the side wall. The total area of the metallic surface may be [20%-100%], or [35%-100%], or [50%-100%], or [50%-80%] of the whole area of the outside surface of the side wall. These options may apply to any embodiment in this disclosure.

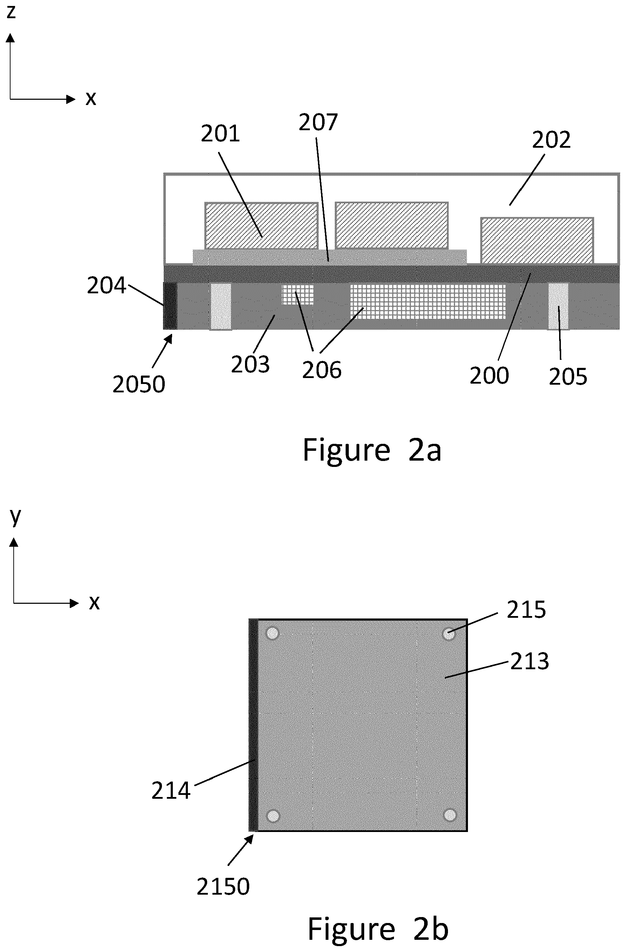

Figure 2a illustrates another example of a sectional view of an electronic component with a bottom package comprising a side wall wherein the outside surface of the side wall comprises a metallic surface. The component may be a Micro Inertial Measurements Unit (IMU) module. In this example, the electronic component comprises an internal horizontal circuit board 200 to which a plurality of dies 201 and 207, such as MEMS and ASIC dies, are electrically connected. The electronic component further comprises a top package 202 which is attached to the top side of the internal horizontal circuit board 200 and encloses the dies 201 and 207. The electronic component further comprises a bottom package 203 which may be formed on the bottom side of the internal horizontal circuit board 200 by molding technique. The electronic component may further comprise additional dies 206 and/or a plurality of pillars 205 which are attached to the bottom surface of the internal horizontal circuit board 200 and are embedded in the bottom package 203. The additional dies 206 may either be similar or different. They may comprise active devices such as MEMS dies and/or ASIC dies and/or microcontroller units. They may alternatively or additionally comprise passive devices such as capacitors, inductors, resistors, transformers, diodes. The pillars 205 extend along the z-direction from the bottom side of the internal horizontal circuit board to the bottom side of the component. The pillars 205 may be substantially evenly distributed in the internal horizontal circuit board area. They may be randomly or symmetrically arranged. They may be made of a variety of metals that include but are not limited to Cu, Ni, Al, Ag, Au, Pt, Pd, Mo or metal alloys. The pillars may either be used as electrical contacts or as dummies with no electrical function. The bottom package 203 comprises a side wall 2050. The outside surface of the side wall comprises a metallic surface 204. In this example, the metallic surface 204 extends in the z-direction from the bottom side of the internal horizontal circuit board 200 to the bottom side of the component. The options presented in this paragraph may apply to any embodiment presented in this disclosure.

The electronic component illustrated in figure 2a may have one of the bottom views illustrated in figures 2b-2d.

Figure 2b illustrates one possible example of the bottom view of the electronic component shown in figure 2a. The bottom package 213 comprises a side wall 2150 and the outside surface of the side wall comprises a metallic surface 214. In this example, the metallic surface 214 covers the entire outside surface of the side wall extending along the y-direction from an edge of the bottom package to the opposite edge of the bottom package. Reference number 215 in figure 2b corresponds to reference number 205 in figure 2a.

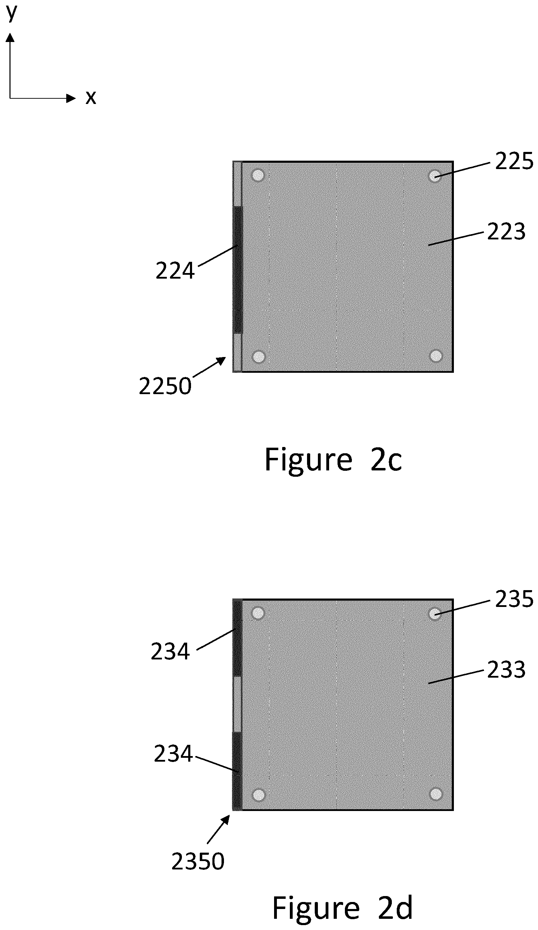

Figure 2c illustrates another possible example of the bottom view of the electronic component shown in figure 2a. The bottom package 223 comprises a side wall 2250 and the outside surface of the side wall comprises a metallic surface 224. The metallic surface 224 constitutes only a portion of the full outside surface of the side wall. In this example, it extends along the y-direction in the middle area of the side wall. Alternatively, it may be adjacent, in the y-direction, to one of the edges of the side wall. Reference number 225 in figure 2c corresponds to reference number 205 in figure 2a.

The outside surface of the side wall may comprise more than one metallic surface. The total area of the metallic surfaces may be [20%-80%], or [35%-80%], or [50%-80%] of the total area of the outside surface of the side wall. These options may apply to any embodiment in this disclosure. Figure 2d illustrates another possible example of the bottom view of the electronic component shown in figure 2a. In this example, the bottom package 233 comprises a side wall 2350. The outside surface of the side wall comprises two metallic surfaces 234. The metallic surfaces are separated by an insulating layer. In this example, the insulating layer is a bulging portion of the bottom package 233. Alternatively, the metallic surfaces may be separated by another insulating medium such as air. Reference number 235 in figure 2d corresponds to reference number 205 in figure 2a.

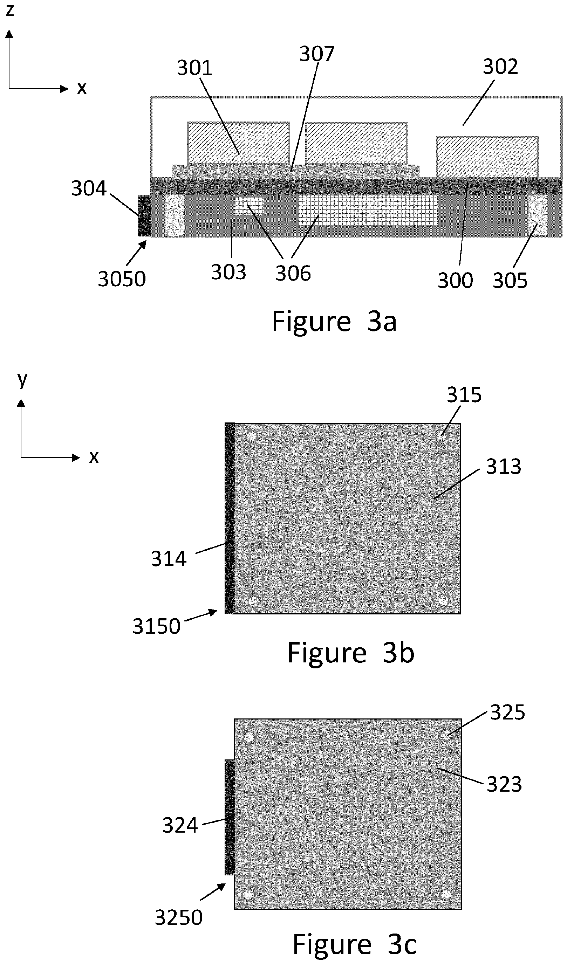

Figure 3a illustrates another example of a sectional view of an electronic component with a side wall comprising a metallic surface. The electronic component comprises an internal horizontal circuit board 300 to which a plurality of dies 301 and 307 are attached. The electronic component further comprises a top package 302 and a bottom package 303 comprising a side wall 3050. In this example, the outside surface of the side wall comprises a protuberant metallic surface 304 that extends in the z-direction from the edge of the internal horizontal circuit bord 300 to the bottom of the package and extends in the x-direction beyond the edge of the internal horizontal circuit board 300. In other words, the metallic surface 304 protrudes in the x-direction outward the plane formed by the top package wall which is parallel to the yz-plane. Reference numbers 305 and 306 in figure 3a correspond to reference numbers 205 and 206, respectively, in figure 2a.

The electronic component illustrated in figure 3a may have one of the bottom views illustrated in figures 3b-3c.

Figure 3b illustrates a possible example of the bottom view of the electronic component shown in figure 3a. The bottom package 313 comprises a side wall 3150 and the outside surface of the side wall comprises a metallic surface 314. In this example, the metallic surface 314 forms the whole outside surface of the side wall extending along the y-direction from an edge of the bottom package to the opposite edge of the bottom package. Reference number 315 in figure 3b corresponds to reference number 205 in figure 2a.

Figure 3c illustrates another possible example of the bottom view of the electronic component shown in figure 3a. The bottom package 323 comprises a side wall 3250 and the outside surface of the side wall comprises a metallic surface 324. The metallic surface 324 constitutes only a portion of the whole outside surface of the side wall. In this example, the metallic surface 324 extends along the y-direction in the middle area of the side wall. Alternatively, it may be adjacent to one of the edges of the side wall. Reference number 325 in figure 3c corresponds to reference number 205 in figure 2a.

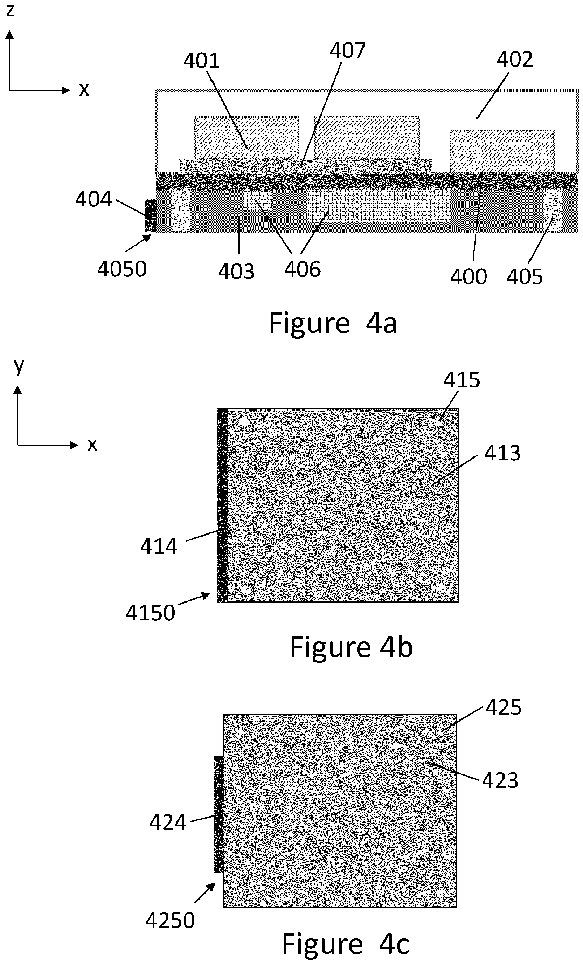

Figure 4a illustrates another example of a sectional view of an electronic component with a bottom package comprising a metallic surface. The electronic component comprises an internal horizontal circuit board 400 to which a plurality of dies 401 and 407 are attached. The electronic component further comprises a top package 402 and a bottom package 403 comprising a side wall 4050. In this example, the outside surface of the side wall comprises a metallic surface 404 that forms only a portion of the full outside surface of the side wall. The metallic surface 404 extends in the z-direction from a position located below the horizontal circuit board 400 to the bottom of the package and bulges in the x-direction outward the plane formed by the side wall of the top package. Reference numbers 405 and 406 in figure 4a correspond to reference numbers 205 and 206, respectively, in figure 2a.

The electronic component illustrated in figure 4a may have one of the bottom views illustrated in figures 4b-4c.

Figure 4b illustrates a possible example of the bottom view of the electronic component shown in figure 4a. The bottom package 413 comprises a side wall 4150 and the outside surface of the side wall 4150 comprises a metallic surface 414. In this example, the metallic surface 414 extends along the y-direction from an edge of the bottom package to the opposite edge of the bottom package. Reference number 415 in figure 4b corresponds to reference number 205 in figure 2a.

Figure 4c illustrates another possible example of the bottom view of the electronic component shown in figure 4a. The bottom package 423 comprises a side wall 4250 and the outside surface of the side wall comprises a metallic surface 424. In this example, the metallic surface 424 extends along the y-direction only in the middle area of the side wall.

Alternatively, it may be adjacent to one of the edges of the side wall. Reference number 425 in figure 4c corresponds to reference number 205 in figure 2a.

The metallic surface may be indented in the side wall. The metallic surface may be a groove-shaped surface comprising one or more castellations. It may be the whole outside surface of the side wall. Alternatively, it may constitute a portion of the total outside surface of the side wall.

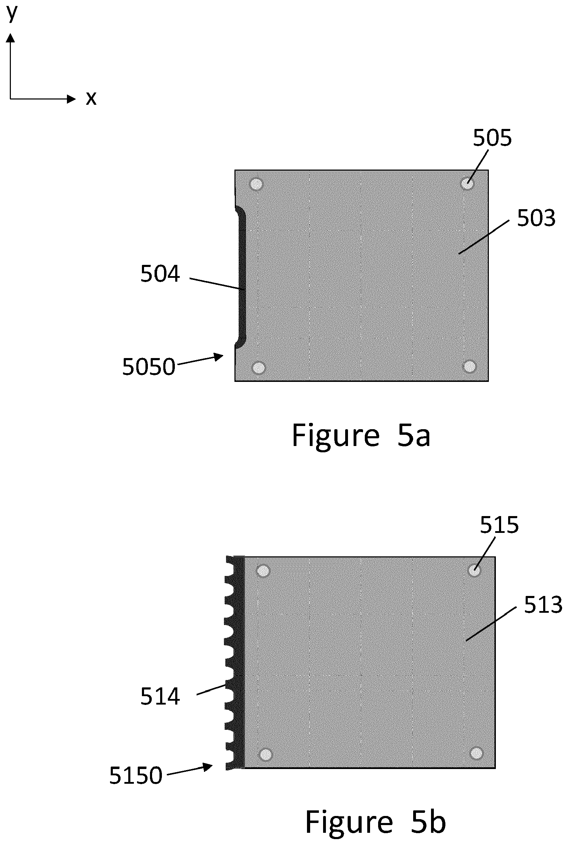

Figures 5a illustrates an example of the bottom view of an electronic component with a bottom package 503 comprising a side wall 5050. The outside surface of the side wall comprises a metallic surface. In this example, the metallic surface 504 is indented in the side wall. Reference number 505 in figure 5a corresponds to reference number 205 in figure 2a.

Figures 5b illustrates another example of the bottom view of an electronic component with a bottom package 513 comprising a side wall 5150. The outside surface of the side wall comprises a metallic surface 514 which extends in the y-direction from an edge of the bottom package to the opposite edge of the bottom package. In this example, the metallic surface 514 is a groove-shaped surface comprising a plurality of castellations. Reference number 515 in figure 5b corresponds to reference number 205 in figure 2a.

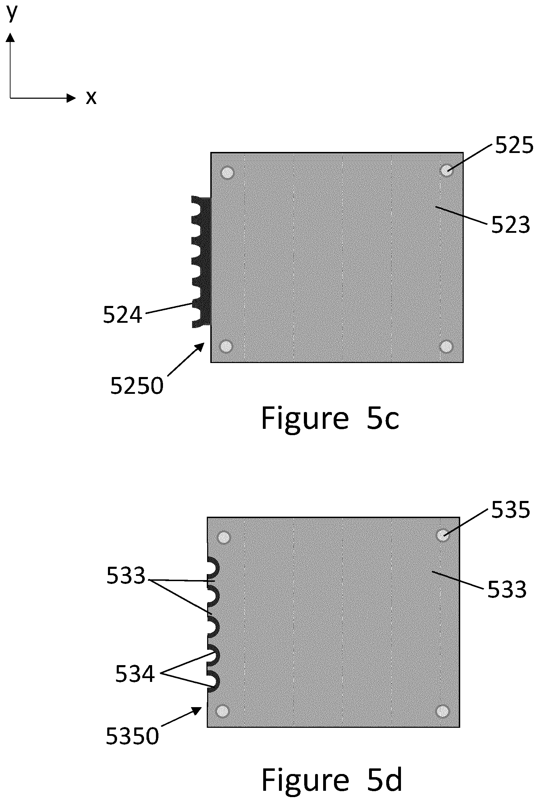

Figure 5c illustrates another example of the bottom view of an electronic component with a bottom package 523 comprising a side wall 5250. The outside surface of the side wall comprises a metallic surface 524 and the metallic surface 524 is a is a groove-shaped surface comprising several castellations. The metallic surface 524 covers a portion of the outside surface of the side wall and extends along the y-direction in the middle area of the side wall. Alternatively, the metallic surface may be adjacent in the y-direction to one of the edges of the bottom package. Reference number 525 in figure 5c corresponds to reference number 205 in figure 2a.

The outside surface of the side wall may further comprise insulating areas, wherein the one or more castellations are arranged next to each other with the insulating areas located between them. Figure 5d illustrates another example of the bottom view of an electronic component with a bottom package 533 comprising a side wall 5350. In this example, a plurality of metallic surfaces 534 are indented in the side wall forming castellations located next to each other and separated by protruding insulating areas from the bottom package 533. Reference number 535 in figure 5d corresponds to reference number 205 in figure 2a.

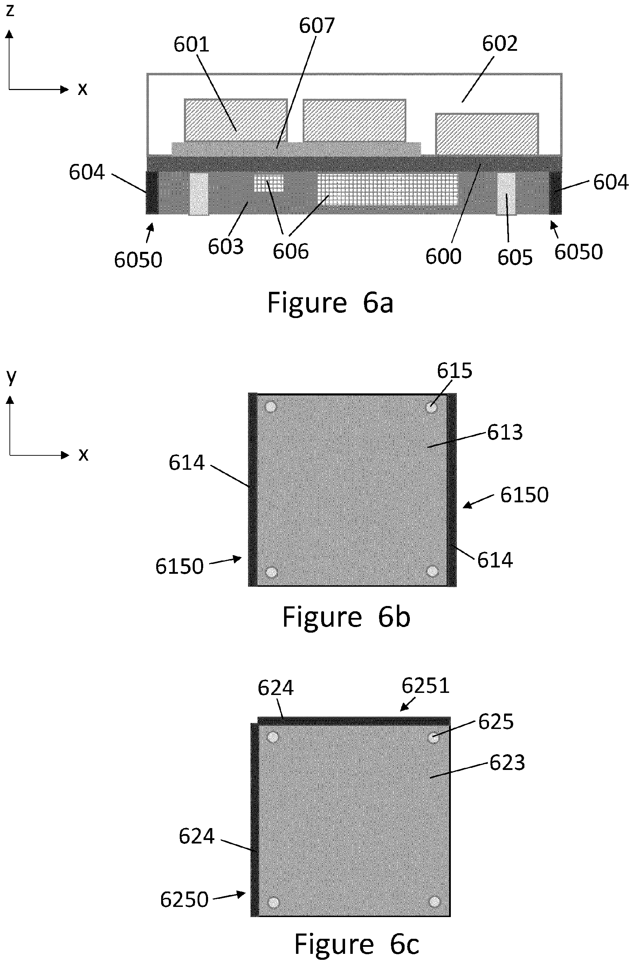

The electrical component may comprise more than one side wall comprising a metallic surface. Figures 6a illustrates an example of a sectional view of an electronic component with a bottom package 603. The bottom package 603 comprises two side walls 6050 wherein each of the side wall comprises an outside surface and each outside surface comprises a metallic surface 604. In this example, the side walls 6050 are parallel to each other. Alternatively, the side walls may be perpendicular to each other. As an additional option, the walls comprising the metallic surface may be a combination of side walls which are parallel to each other and other side walls which are perpendicular to each other. These options may apply to any embodiment presented in this disclosure. Reference numbers 600, 601, 602, 605, 606 and 607 in figure 6a correspond to reference numbers 200, 201, 202, 205, 206 and 207, respectively, in figure 2a.

Figure 6b illustrates a possible example of the bottom view of the electronic component shown in figure 6a. The component comprises a bottom package 613 and two side walls 6150 wherein the outside surface of each side wall comprises a metallic surface 614. In this example, the side walls 6150 are parallel to each other. Reference number 615 in figure 6b corresponds to reference number 205 in figure 2a.

Figure 6c illustrates an example of the bottom view of another electronic component with a bottom package comprising two side walls, 6250 and 6251, wherein the outside surface of each side wall comprises a metallic surface 624. In this example, the side walls, 6250 and 6251, are perpendicular to each other. Reference numbers 623, and 625 in figure 6c correspond to reference numbers 203 and 205, respectively, in figure 2a.

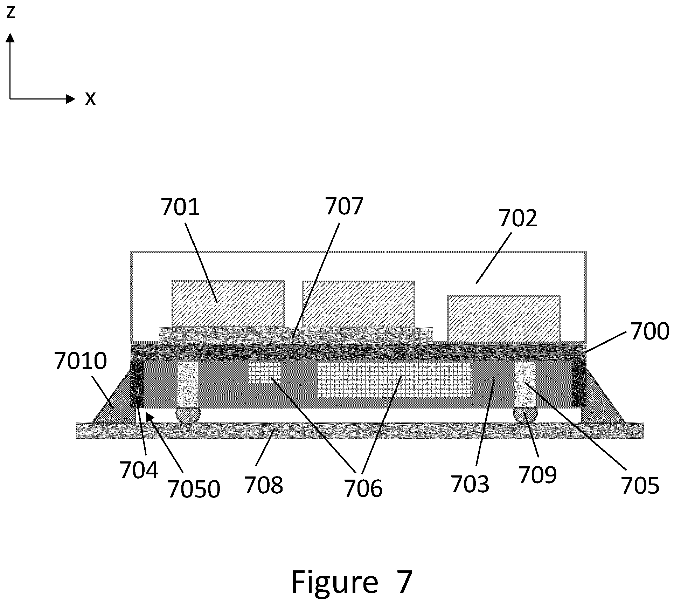

The electrical component may be electrically connected to an external printed circuit board via soldering bumps. Figure 7 illustrates an example of a sectional view of an electrical component connected to an external horizontal circuit board 708 via solder bumps 709. In this example, the electronic component comprises a bottom package 703 comprising two parallel side walls 7050 and the outside surface of each side wall comprises a metallic surface 704. In addition to the solder bumps which are connected to the bottom base of the pillars 705, the metallic surface 704 of each side wall may also be soldered to the external circuit board 708 using additional solder metal. The additional solder metal forms vertical solder connections 7010. The vertical solder connections 7010 enable more yielding and less stress for the solder. The increase of the solder area and height results in the improvement of Board Level Reliability of the component. Reference numbers 700, 701, 702, 706 and 707 in figure 7 correspond to reference numbers 200, 201, 202, 206 and 207, respectively, in figure 2a.

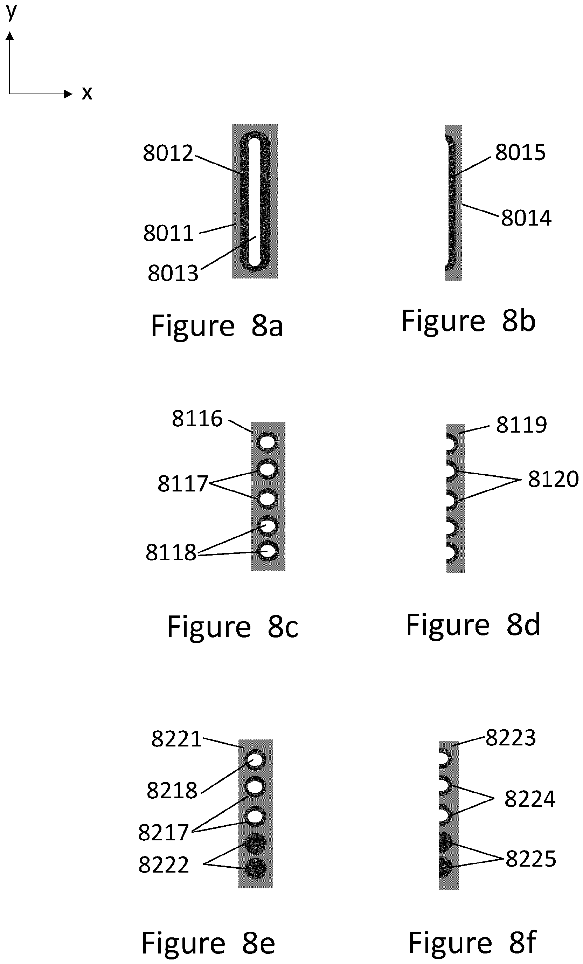

The side wall may be formed using a circuit board. Alternatively, the side wall may be formed using other applicable materials and/or structures, and/or shapes such as ceramics or blind vias. Figures 8a-8f illustrate schematically examples of different circuit boards that may be used to form side walls in a bottom package wherein the outside surface of the side walls comprises a metallic surface. In these examples, the formed side walls comprise one or more castellations. The one or more castellations are oriented in the vertical direction.

Figure 8a illustrates an example of a printed circuit board 8011 comprising a long narrow via 8013 that extends along the y-direction. The circuit board 8011 further comprises an inner metallic surface 8012. The inner metallic surface of the circuit board refers here to the metallic surface surrounding the via 8013. Figure 8b illustrates the circuit board shown in figure 8a after being cut along the y-direction. In this example, the cut circuit board 8014 comprises a side metallic surface 8015 indented in the recess formed by cutting the via in the y-direction. The cut circuit board 8014 may be attached to a lateral side of the bottom package of an electronic component so that the metallic surface 8015 faces the surrounding of the bottom package.

Figure 8c illustrates another example of a printed circuit board 8116 which may be used to form a side wall wherein the outside surface of the side wall comprises a metallic surface. The circuit board 8116 comprises a plurality of vertical vias 8118 that extends along the z-direction. Each of the vias or some of the vias may comprise an inner metallic surface. In this example, all vias comprise an inner metallic surface 8117. The inner metallic surface of a via refers here to the metallic surface surrounding the same via. Figure 8d illustrates the circuit board shown in figure 8c after being cut along the y-direction. In this example, the cut circuit board 8119 has a castellations-shaped side in which a portion of the inner metallic surface of each via is indented forming several outer metallic surfaces 8120 separated by insulating areas. The cut circuit board 8119 may be attached to a lateral side of the bottom package of an electronic component so that the castellations-shaped side forms the outside surface of the side wall.

Figure 8e illustrates another example of a printed circuit board 8221 which may be used to form a side wall wherein the outside surface of the side wall comprises a metallic surface. The circuit board 8221 may comprise a plurality of vertical vias 8218 that extends along the z-axis. Each of the vias may comprise an inner metallic surface 8217. The inner metallic surface of a via refers here to the metallic surface surrounding the same via. The circuit board 8221 may further comprise blind vias 8222. A blind via refers to a via that is filled with a solid substance. The solid substance may be metal. Figure 8f illustrates the circuit board shown in figure 8e after being cut along the y-direction. In this example, the cut circuit board 8223 has a side comprising two parts; a first groove-shaped part, comprising vertical castellations, in which a portion of the inner metallic surface of each via is indented thereby forming a first set of outer metallic surfaces 8224, and a second flat part comprising several flat metallic areas that result from cutting the blind vias. The flat metallic areas form a second set of outer metallic surfaces 8225. The cut circuit board 8223 may be attached to a lateral side of the bottom package of an electronic component so that the side comprising the first set of outer metallic surfaces and the second set of outer metallic surfaces faces the surrounding of the bottom package.

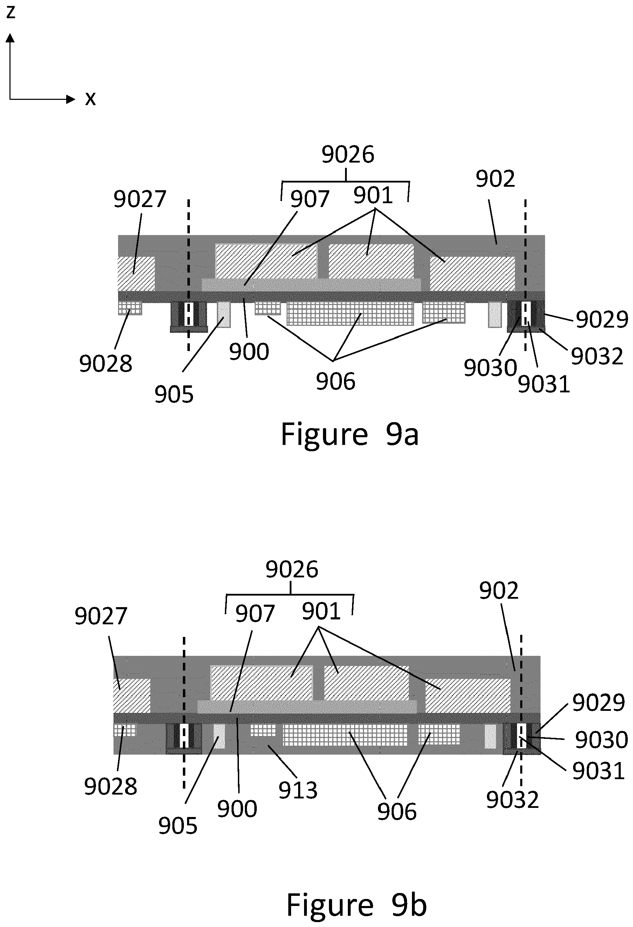

Figures 9a-9c provide a simplified illustration of an example method for forming at least one side wall in the bottom package of an electronic component wherein the outside surface of the side wall comprises a metallic surface. The electronic component comprises a horizontal circuit board with a top side and a bottom side. The horizontal circuit board defines a horizontal xy-plane and a vertical z-direction which is perpendicular to the xy-plane. The horizontal circuit board comprises a first region in the xy-plane and one or more vertical circuit boards comprising one or more vias. The one or more vias comprise an inner metallic surface.

The method comprises: (1) attaching a first set of dies to the top side of the horizontal circuit board in the first region, (2) forming a top package on the top side of the horizontal circuit board around the first set of dies so that the first set of dies are enclosed in the top package, (3) attaching the one or more vertical circuit boards to the bottom surface of the horizontal circuit board in the dicing regions, (4) forming a bottom package on the bottom side of the horizontal circuit board, (5) dicing the electronic component in the dicing region along the z-direction from the top surface of the top package to the bottom surface of the bottom package so that the inner metallic surface of the one or more vias is exposed.

Figures 9a illustrates steps (1)-(3) of the example method for forming at least one side wall in the bottom package of an electronic component wherein the outside surface of the side wall comprises a metallic surface. The electronic component comprises an internal horizontal circuit board 900 and the internal horizontal circuit board 900 comprises a first region in the xy-plane and a second region in the xy-plane which are adjacent to each other. "Internal horizontal circuit board" refers here to the horizontal circuit board that is part of the component and to which the dies are attached. A first set of dies 9026 is attached to the top side of the internal horizontal circuit bord 900 in the first region. A second set of dies 9027 may be attached to the top side of the internal horizontal circuit board in the second region. The first set of dies and the second set of dies may comprise one or more dies which may be similar or different. In this example, the first set of dies 9026 comprises different dies, 901 and 907, which may be MEMS and ASIC dies whereas the second set of dies 9027 comprises a single die. After attaching the first set of dies 9026 and the second set of dies 9027 to the internal horizontal circuit board 900, a top package 902 is formed on the top side of the internal horizontal circuit board 900 so that it encloses the first set of dies 9026 and the second set of dies 9027. The top package 902 may either be a hollow plastic frame, a metal cap, or a molded solid substance. The molded solid substance may be made of materials that include low conductivity or insulating materials such as mold compounds, polymers, plastics, ceramics, or resins. These options may apply to any embodiment in this disclosure. In this example, the top package 902 is a molded solid substance such as resin. After forming the top package, one or more vertical circuit boards may be attached to the bottom surface of the internal horizontal circuit board in the dicing regions. "Dicing region" refers to the areas where the component is subsequently to be diced along the z-direction. They are marked with dash lines on figures 9a-9b. In this example, one of the dicing areas separates the first region and the second region, and two vertical circuit boards 9029 comprising a plurality of vertical vias 9031 are used to form side walls. Each via of the vertical circuit boards comprises an inner metallic surface 9030. The vertical circuit boards 9029 are attached to the bottom surface of the internal horizontal printed circuit board 900 in the dicing regions so that the top base of the vias of each circuit board is adjacent to the bottom surface of the horizontal circuit board and the bottom base of the vias of each circuit board is opposite to the top base of the vias in the z-direction. In this example, the bottom base of the vias in each vertical circuit board 9029 is covered with a seal 9032. The seal 9032, which is a solder mask, is an inherent part of the boards 9029. Alternatively, when the bottom of the vias in the vertical circuit boards is open, the method may further comprise the steps of covering the bottom base of the vias with a seal after attaching the one or more vertical circuit boards to the bottom surface of the horizontal circuit board, then grinding the bottom of the bottom package after forming the bottom package so that the seal is removed. The seal may be used to cover the bottom of the structures comprising the vias so that the solid substance of the bottom package does not penetrate the vias. The seal may be a plastic plug, a protective film, a sheet of metal, or plated metal covering the via.

The method may further comprise attaching a first set of additional dies to the bottom surface of the horizontal circuit board in the first region. In this example, a first set of additional dies 906 comprising several dies is attached to the bottom surface of the internal horizontal circuit board in the first region, and a second set of additional dies 9028 comprising a single die is attached to the bottom of the internal horizontal circuit board 900 in the second region. The first set of additional dies and the second set of additional dies may either be similar or different. They may comprise active devices such as MEMS dies and/or ASIC dies and/or microcontroller units. Alternatively, or additionally, they may comprise passive devices such as capacitors, inductors, resistors, transformers, diodes.

The method may further comprise attaching a plurality of metallic pillars to the bottom surface of the horizontal circuit board so that the pillars extend from the bottom surface of the horizontal circuit board along the z-direction. The pillars may be substantially evenly distributed on the bottom surface of the horizontal circuit board. They may be randomly or symmetrically arranged. They may be made of a variety of metals that include but are not limited to Cu, Ni, Al, Ag, Au, Pt, Pd, Mo or metal alloys. The pillars may either be used as electrical contacts or as dummies with no electrical function. In this example, metallic pillars 905 are attached to the bottom surface of the internal horizontal circuit board 900 on each side of first set of additional dies 906, so that they are located between the vertical circuit boards 9029.

Figures 9b illustrates the step where a bottom package 913 is formed on the bottom side of the internal horizontal circuit board 900 so that it encloses the vertical circuit boards 9029, the metallic pillars 905, the first set of additional dies 906 and the second set of additional dies 9028. The bottom package 913 may be formed by molding technique using materials that may include low conductivity or insulating materials such as mold compounds, polymers, plastics, ceramics, or resins.

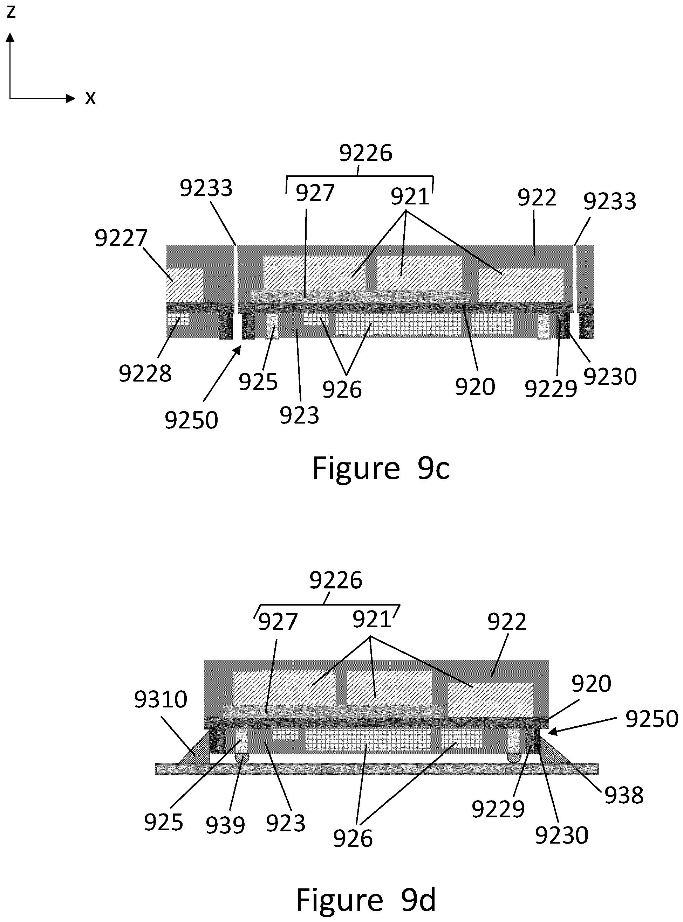

Figure 9c illustrates the following steps of the example method which comprise grinding and dicing. After forming the bottom package, the bottom of the bottom package is grinded so that the seals 9032 are removed and the bottom of the metallic pillars 925 emerges from the bottom package 923. The component is afterwards diced along the z-direction through the dicing regions 9233 from the top surface of the top package 922 to the bottom surface of the bottom package 923. Simultaneously, the vertical circuit boards are diced along the z-direction forming two side walls 9250 on opposite sides of the bottom package 923. In this example, the vias are cut perpendicularly through the top base and the bottom base so that the inner metallic surface of the vias is exposed. In other words, each diced vertical circuit board 9229 has a castellations-shaped side facing the surrounding of the diced component. A portion of the inner metallic surface of each via is indented in the castellations-shaped side thereby forming several metallic surfaces 9230 separated by insulating areas in each side wall of the bottom package. Solder material may subsequently be soldered to the metallic surfaces 9230. Reference number 920 in figure 9c corresponds to reference number 200 in figure 2a. Reference numbers 921, 926, 927, 9226, 9227 and 9228 in figure 9c correspond to reference numbers 901, 906, 907, 9026, 9027 and 9028, respectively, in figure 9a.

Figures 9d shows the electronic component manufactured using the method illustrated in figures 9a-9c after it is connected to an external circuit board using soldering method. "External circuit board" refers here to a circuit board to which the component may be attached. The component may be a Micro Inertial Measurements Units (IMU) module. In this example, the electronic component comprises a bottom package 923 comprising two parallel side walls 9250 formed by the diced circuit boards 9229. Each of the side walls has a castellations-shaped side comprising several outside metallic surfaces 9230. In addition to the solder bumps 939 which are connected to the bottom base of the pillars 925, the metallic surfaces 9230 of each side wall may also be soldered to the external horizontal circuit board 938 using additional solder metal. The additional solder metal forms additional vertical solder connections 9310. This results in the improvement of the Board Level Reliability of the component.

## Claims

1. An electronic component comprising:
- a horizontal circuit board with a top side and a bottom side, wherein the horizontal circuit board defines a horizontal xy-plane and a vertical z-direction which is perpendicular to the xy-plane,
- one or more dies attached to the top side of the horizontal circuit board,
- a top package, wherein the top package is attached to the top side of the horizontal circuit board and surrounds the one or more dies,
- a bottom package, wherein the bottom package is attached to the bottom side of the horizontal circuit board so that the bottom surface of the bottom package forms the bottom side of the component,
**characterized in that**
the bottom package comprises at least one side wall, wherein the side wall comprises an outside surface, and wherein the outside surface comprises a metallic surface.

2. An electronic component according to claim 1, wherein the metallic surface is a flat surface.

3. An electronic component according to claim 1, wherein the metallic surface is indented in the side wall.

4. An electronic component according to claim 3, wherein the metallic surface is a groove-shaped surface comprising one or more castellations.

5. An electronic component according to claim 4, wherein the one or more castellations are oriented in the vertical direction.

6. An electronic component according to claims 5, wherein the outside surface further comprises insulating areas, and wherein the one or more castellations are arranged next to each other with the insulating areas located between them.

7. A method for manufacturing an electronic component, wherein the electronic component comprises:
- a horizontal circuit board with a top side and a bottom side, wherein the horizontal circuit board defines a horizontal xy-plane and a vertical z-direction which is perpendicular to the xy-plane, and wherein the horizontal circuit board comprises a first region in the xy-plane,
- one or more vertical circuit boards comprising one or more vias, wherein the one or more vias comprise an inner metallic surface,
**characterized in that** the method comprises:
- Attaching a first set of dies to the top side of the horizontal circuit board in the first region.
- Forming a top package on the top side of the horizontal circuit board around the first set of dies so that the first set of dies are enclosed in the top package.
- Attaching the one or more vertical circuit boards to the bottom surface of the horizontal circuit board in the dicing regions.
- Forming a bottom package on the bottom side of the horizontal circuit board.
- Dicing the electronic component in the dicing region along the z-direction from the top surface of the top package to the bottom surface of the bottom package so that the inner metallic surface of the one or more vias is exposed.

8. A method for manufacturing an electronic component according to claim 7, wherein the method further comprises the steps of covering the bottom base of the vias with a seal after attaching the one or more vertical circuit boards to the bottom surface of the horizontal circuit board, then grinding the bottom of the bottom package after forming the bottom package so that the seal is removed.

9. A method for manufacturing an electronic component according to any of the previous claims, wherein the method further comprises attaching a plurality of metallic pillars to the bottom surface of the horizontal circuit board so that the pillars extend from the bottom surface of the horizontal circuit board along the z-direction and the pillars are substantially evenly distributed on the bottom surface of the horizontal circuit board.

10. A method for manufacturing an electronic component according to any of the previous claims, wherein the method further comprises attaching a first set of additional dies to the bottom surface of the horizontal circuit board in the first region.
